**Europäisches Patentamt**

**European Patent Office**

**Office européen des brevets**

(19)

(11) Veröffentlichungsnummer: **0 075 638**

**B1**

(12) # EUROPÄISCHE PATENTSCHRIFT

(45) Veröffentlichungstag der Patentschrift:
**08.04.87**

(51) Int. Cl.⁴: **H 05 K 7/14**

(21) Anmeldenummer: **81710048.0**

(22) Anmeldetag: **29.09.81**

(54) **Riegel zum Verspannen eines elektronischen Gerätes an einer Geräteaufnahme.**

(43) Veröffentlichungstag der Anmeldung:
**06.04.83 Patentblatt 83/14**

(45) Bekanntmachung des Hinweises auf die Patenterteilung:
**08.04.87 Patentblatt 87/15**

(84) Benannte Vertragsstaaten:
**DE FR GB IT**

(56) Entgegenhaltungen:
**DE-B-2 112 587**
**DE-U-7 314 871**
**FR-A-1 345 046**
**US-A-3 640 141**

(73) Patentinhaber: **Stop- Choc Schwingungstechnik GmbH & Co KG, Benzstrasse 42, D-7253 Renningen (DE)**

(72) Erfinder: **Schaefer, Lothar, Hummelbau 22, D-7253 Renningen (DE)**

(74) Vertreter: **Ostertag, Ulrich, Patentanwälte Dr. Ulrich Ostertag Dr. Reinhard Ostertag Eibenweg 10, D-7000 Stuttgart 70 (DE)**

EP 0 075 638 B1

LIBER, STOCKHOLM 1987

## Beschreibung

Die Erfindung betrifft einen Riegel zum Verspannen eines elektronischen Gerätes an einer Geräteaufnahme gemäß dem Oberbegriff des Anspruches 1.

Ein derartiger Riegel ist in dem DE-U- 74 11 107 beschrieben. Bei ihm besteht die Federanordnung aus einem Tellerfederstapel, und durch zusammenarbeitende Anschlagschultern auf dem Haltering und dem Spannring wird der axiale Federweg begrenzt, wodurch dann die Sollspannkraft des Riegels ebenfalls vorgegeben ist.

Nachteilig ist an einem solchen Riegel, daß die Riegelspannkraft im Einzelfalle nicht präzise vorgegeben ist, da die Tellerfedern jeweils fertigungsbedingt Toleranzen in ihrer Federcharakteristik aufweisen. Außerdem läßt sich die Riegelspannkraft nicht in definierter Weise variieren, und auf den Riegel einwirkende Vibrationen und Stöße werden nicht gedämpft, da ein Tellerfederstapel nur eine geringe Schwingungsdämpfung bewerkstelligen kann.

In der DE-B- 21 12 587 ist ferner ein Riegel zum Verspannen eines elektronischen Gerätes an einer Geräteaufnahme beschrieben, bei welchem anstelle der axialen Anschlagschultern von Spannring und Haltering eine Überlast-Rutschkupplung zur Begrenzung des Spanndrehmomentes vorgesehen ist. Auch bei diesem Riegel ist ein Tellerfederstapel zum axialen Vorspannen des Halteringes vorgesehen, sodaß man wiederum keine gute Schwingungsdämpfung erhält. Außerdem hat dieser bekannte Riegel verhältnismäßig komplizierten Aufbau und ist recht teuer, da auch die Überlast-Rutschkupplung nach den strengen Richtlinien für das Haupteinsatzgebiet derartiger Riegel, nämlich der Luftfahrtindustrie, gefertigt werden muß.

Durch die vorliegende Erfindung soll daher ein Riegel der eingangs angesprochenen Art so weiter gebildet werden, daß eine bessere Schwingungsdämpfung bei einfachem mechanischem Aufbau erhalten wird.

Diese Aufgabe ist erfindungsgemäß gelöst durch einen Riegel gemäß Anspruch 1.

Bei dem erfindungsgemäßen Riegel ist als Federelement ein Ganzmetall-Federkissen vorgesehen. Unter einem solchen soll ein Federelement verstanden werden, welches im wesentlichen durchgehende äußere Begrenzungsflächen hat, bei Betrachtung aus der Ferne also den Eindruck eines massiven Bauelementes vermittelt; bei genauer Betrachtung hat jedoch das Federkissen die Struktur eines orientierten Metalldraht-Filzes, d.h. die einzelnen endlosen Drähte aus Federdrahtmaterial liegen nicht regelmäßig geordnet neben- und übereinander, sodaß zwischen den einzelnen Metalldrähten Hohlräume verbleiben. Derartige Federelemente sind an sich bekannt.

Bei der vorliegenden Erfindung wird nun von einer Eigenschaft dieser an sich bekannten Federkissen Gebrauch gemacht, welche bei den üblichen Anwendungsgebieten nicht von Interesse ist, nämlich von der speziellen Oberflächenstruktur des Federkissens. Bei einem Ganzmetall-Federkissen laufen die Drähte an der Oberfläche zumindest stückweise parallel zur Oberfläche, sodaß man insgesamt eine glatte Lauffläche erhält, die unter kleiner Reibungskraft gegenüber einer glatten Gegenfläche bewegt werden kann. Dieses Merkmal ist bei dem erfindungsgemäßen Riegel deshalb von Vorteil, weil sich so das Federkissen ohne Zwischenschaltung eines zusätzlichen Gleitringes auch unter hohen Spannkräften und trotz flächiger Anlage am Haltering gegenüber dem letzteren verdrehen kann, wenn der Spannring angezogen wird.

Bei der vorliegenden Erfindung wird ferner davon Gebrauch gemacht, daß ein Ganzmetall-Federkissen bei großer Kraftbeaufschlagung sowohl plastisch als auch elastisch verformbar ist. Auch nach großer statischer Verformung hat man bei ihm ein gutes dynamisches Federvermögen für kleine Wechselbelastungen. Aufgrund der filzähnlichen Struktur hat das Federkissen auch ein gutes Energieabsorptionsvermögen, sodaß man insgesamt eine breite und niedere Resonanzkurve des Schwingungssystems erhält, welches aus dem Riegel und dem durch den letzteren verspannten elektronischen Gerät gebildet ist.

Da erfindungsgemäß ein Teil des Federkissens sowohl in radialer Auswärtsrichtung als in radialer Einwärtsrichtung durch Wände des Spannringes spielfrei begrenzt ist, kann das Federkissen in diesem Bereich in seiner Außengeometrie nicht geändert werden, kann also nur im Volumen auf Druck beansprucht werden. In dem nicht in radialer Richtung abgestützten Bereich kann das Material des Federkissens bei hoher Axialbelastung dagegen in radialer Richtung ausweichen. Durch Verändern des Verhältnisses zwischen radial abgestütztem und nicht abgestütztem Bereich des Federkissens durch entsprechende, leicht durchführbare Abänderung des z.B. als Drehteil hergestellten Spannringes kann man die Gesamtfedercharakteristik des Riegels auf einfache Weise für einen bestimmten Einsatzzweck einstellen, ohne daß das auf kompliziertere Weise herzustellende Federkissen abgeändert zu werden bräuchte.

Dadurch, daß das Ganzmetall-Federkissen eine progressive Kennlinie aufweist, läßt sich die Riegelspannkraft in weiten Grenzen verändern. Dies kann unter Verwendung eines an das Formschlußverbindungselement ansetzbaren Drehmomentenschlüssels sehr präzise erfolgen, wobei man das Spanndrehmoment auf sehr einfache Weise an die Masse des jeweils zu verspannenden elektronischen Gerätes anpassen kann. Die nach dem Abnehmen des Drehmomentenschlüssels verbleibenden Teile der Geräteverspanneinrichtung haben einen

2

denkbar einfachen und robusten Aufbau; ein Ausfall durch Bruch von Riegelteilen kommt so nicht mehr vor.

Vorteilhafte Weiterbildungen der Erfindung sind in Unteransprüchen angegeben.

Mit der Weiterbildung der Erfindung gemäß Anspruch 2 wird erreicht, daß das Federkissen unverlierbar in dem Spannring gehalten ist, zugleich aber auch leicht über die Halterippe hinweg in die Federkammer hineinbewegt werden kann.

Mit der Weiterbildung der Erfindung gemäß Anspruch 3 wird erreicht, daß die Kraftübertragung vom Haltering auf das Federkissen praktisch über dessen gesamte freie Stirnfläche hinweg gleichförmig erfolgt. Damit wird das insgesamt zur Verfügung stehende Federvolumen des Federkissens gut ausgenützt.

Die Weiterbildung der Erfindung gemäß Anspruch 4 erlaubt eine zusätzliche Variierung der Gesamtfedercharakteristik des Riegels über die axiale Erstreckung und Tiefe der flachen Nut, in welche hinein das Material des Federkissens bei axialer Beanspruchung ausweichen kann.

Die Weiterbildung der Erfindung gemäß Anspruch 5 ist im Hinblick auf einen besonders einfachen und kompakten Aufbau des Spannringes von Vorteil, da der sowieso vorgesehene Stützstutzen zugleich als Träger für das mit dem Gewindebolzen zusammenarbeitende Spannringgewinde dienen kann.

Die Weiterbildung der Erfindung gemäß Anspruch 6 ermöglicht es, den Stützstutzen mit axial kurzer Abmessung auszubilden, wobei trotzdem eine ausreichende Anzahl von Gewindegängen zur Kraftübertragung zwischen Gewindebolzen und Spannring zur Verfügung steht.

Auch die Weiterbildung der Erfindung gemäß Anspruch 7 ist im Hinblick auf ein Variieren der Gesamtfedercharakteristik des mit dem Federkissen bestückten Spannringes bei gleichem Federkissentyp von Vorteil.

Auch die Weiterbildung der Erfindung gemäß Anspruch 8 dient der Variierung der Gesamtfedercharakteristik des Riegels durch einfache Änderung von Drehteilen.

Die Weiterbildung der Erfindung gemäß Anspruch 9 ist im Hinblick auf ein besonders gutes Gleiten der Federkissenstirnfläche auf der Stirnfläche des Halteringes auch bei hoher axialer Kraftbeaufschlagung von Vorteil.

Bei Verwendung eines Federkissens, wie es im Anspruch 10 angegeben ist, erhält man besonders günstige Feder- und Dämpfungseigenschaften gegenüber Vibrationen und Stößen, wie sie in rasch fliegenden Düsenflugzeugen auftreten.

Eine Materialanpassung zwischen dem Material des Halteringes und dem Material des Federkissens wie sie im Anspruch 11 angegeben ist, ist im Hinblick auf ein Vermeiden der Entstehung von Oberflächenrauhigkeiten und ein Ausgleichen von schon vorhandenen Oberflächenrauhigkeiten durch Mikroverdrängung von Material von Vorteil.

Nachstehend wird die Erfindung anhand von Ausführungsbeispielen unter Bezugnahme auf die Zeichnung näher erläutert. In dieser zeigen:

Fig. 1: eine seitliche Ansicht einer Spanneinrichtung für einen Elektronikeinschub eines Flugzeuges, in welcher ein Spannring, ein Ganzmetall-Federkissen und ein Haltering eines Spannriegels axial gesschnitten wiedergegeben sind;

Fig. 2: eine Aufsicht auf die Stirnfläche des in Fig. 1 gezeigten Spannriegels; und

Fign. 3 bis 5 ähnliche Ansichten wie Fig. 1, in welchen abgewandelte Spannriegel wiedergegeben sind.

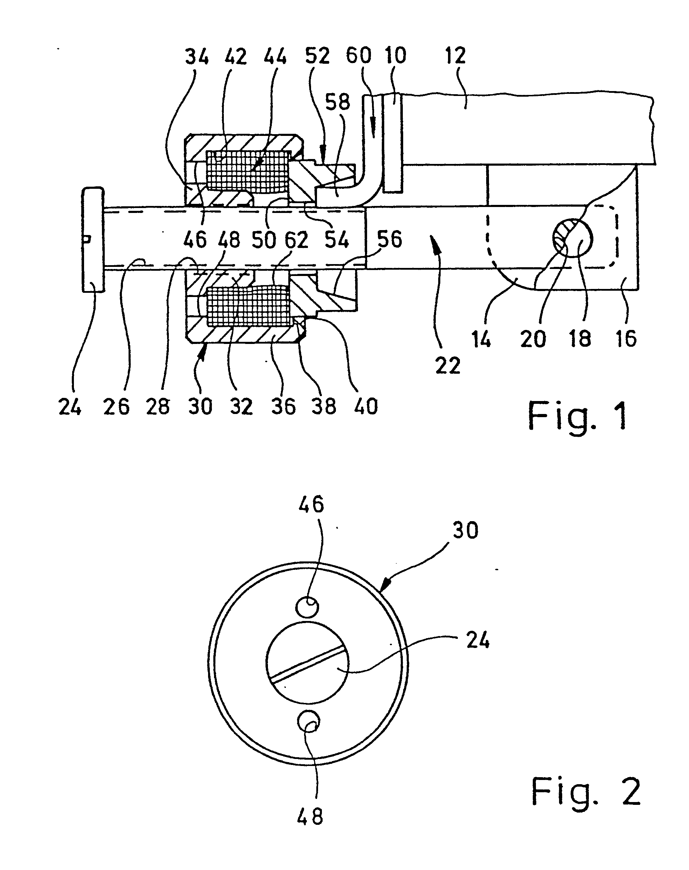

In Fig. 1 ist mit 10 eine Frontplatte eines Elektronikeinschubes eines Flugzeuges bezeichnet. Ein mit dem Flugzeugrahmen fest verbundener Einschubträger 12 umgibt den Elektronikeinschub. An seiner Unterseite sind Lagerplatten 14, 16 befestigt, in denen ein Schwenkbolzen 18 festgelegt ist.

Auf dem Schwenkbolzen 18 läuft eine Lagerbohrung 20, die in der Nähe des freien Endes eines Gewindebolzens 22 in transversaler Erstreckung vorgesehen ist. Am in Fig. 1 links gelegenen Ende ist in den Gewindebolzen 18 eine Schraube 24 eingedreht und verklebt.

Auf dem Gewinde 26 des Gewindebolzens 22 läuft ein Gewinde 28 eines becherförmigen Spannringes 30. Das Gewinde 28 erstreckt sich durch einen mittigen Stützstutzen 32 des Spannringes 30 hindurch, welcher an den Boden 34 des Spannringes 30 angeformt ist. Die axiale Erstreckung des Stützstutzens 32 entspricht etwa 60% der axialen Erstreckung der Umfangswand 36 des Spannringes 30.

An den freien Rand der Umfangswand 36 ist eine radial nach innen vorspringende Halterippe 38 angeformt, welche mit einer kegeligen Einführfläche 40 versehen ist.

In der durch die Umfangswand 36 begrenzten Federkammer 42 ist ein Ganzmetall-Federkissen 44 angeordnet. Dieses hat makroskopisch hohlzylindrische Gestalt und ist durch Kompaktieren eines rundgestrickten Schlauches aus Cr-Ni-Stahldraht in einer Preßform hergestellt. In dem kompaktierten Drahtmaterial mit einer Dichte von etwa 2 g/cm$^3$ verlaufen die einzelnen endlosen Drähte wellenförmig in Umfangsrichtung des Federkissens. Der Außendurchmesser des Federkissens 44 entspricht dem Innendurchmesser der Umfangswand 36; der Innendurchmesser des Federkissens 44 entspricht dem Außendurchmesser des Stützstutzens 32, und die axiale Länge des unverformten Federkissens 44 entspricht dem Abstand der Halterippe 38 vom Boden 34 des Spannringes 30.

Im Boden 34 des Spannringes 30 sind einander diametral gegenüber liegend zwei Bohrungen 46, 48 vorgesehen, in welche Mitnehmerzapfen eines nicht wiedergegebenen Drehmomentenschlüssels einsteckbar sind.

Die freie Stirnfläche des Federkissens 44 liegt an der ebenen glatten Stirnfläche 50 eines Halteringes 52 an, der eine mittige, den Gewindebolzen 22 unter Spiel aufnehmenden Durchgangsöffnung 54 aufweist und auf seiner in Fig. 1 nach rechts weisenden Seite mit einer zur Durchgangsöffnung 54 koaxialen kegelstumpfförmigen Ausnehmung 56 versehen ist. In die letztere greift ein abgewinkelter Endabschnitt 58 eines Spannhakens 60 ein, der an der Frontplatte 10 des Elektronikeinschubes befestigt ist.

Der Außendurchmesser des Halteringes 52 ist im Hinblick auf eine Spielpassung zur Halterippe 38 gewählt, sodaß die Stirnfläche 50 des Halteringes 52 die freie Stirnfläche des Federkissens 44 praktisch vollständig überdeckt.

Der oben beschriebene Spannriegel für Elektronikeinschübe wird folgendermaßen hergestellt:

Der Gewindebolzen 22, der Spannring 30 und der Haltering 52 werden auf einer Drehbank aus einem Stahl der gewünschten Festigkeit hergestellt. Dann wird das Federkissen 44, welches wie oben beschrieben aus einem rundgestrickten Stahldrahtgewirk hergestellt ist, unter elastisch-radialer Verformung an der Halterippe 38 vorbei in die Federkammer 42 gedrückt. Hierauf wird der Spannring 30 auf den Gewindebolzen 22 aufgeschraubt und durch Einschrauben und Verkleben der Schraube 24 gegen ein Abnehmen gesichert. Der Haltering 52 kann zusammen mit dem Spannring 30 auf den Gewindebolzen 22 gebracht werden oder danach vom freien Ende des Gewindebolzens 22 her aufgeschoben werden.

Durch Einsetzen des Schwenkbolzens 18 in die Lagerplatten 14 und 16 sowie die Lagerbohrung 20 wird der Gewindebolzen 22 am Einsatzort mit dem Einschubträger 12 verbunden. Nach Einsetzen des Elektronikeinschubes in den Einschubträger 12 wird dann der Spannring 30 zunächst von Hand gegen die Frontplatte 10 geschraubt. Sowie ein Kraftschluß zwischen dem Spannhaken 60 und dem Spannring 30 über den Haltering 52 hergestellt ist, wird ein Drehmomentenschlüssel an den Bohrungen 46, 48 des Spannringes 30 angesetzt und letzterer wird solange angezogen, bis das am Drehmomentenschlüssel eingestellte Solldrehmoment erreicht ist.

Bei dieser Spannbewegung bewegt sich die Stirnfläche 50 des Halteringes 52 in die Federkammer 42 hinein, wie aus Fig.1 ersichtlich, und drückt das Material des Federkissens 44 zusammen. Hierbei kann der radial nach innen nicht abgestützte, in Fig. 1 rechts gelegene Teil des Federkissens 44 etwas ausbauchen, wie bei 62 gezeigt.

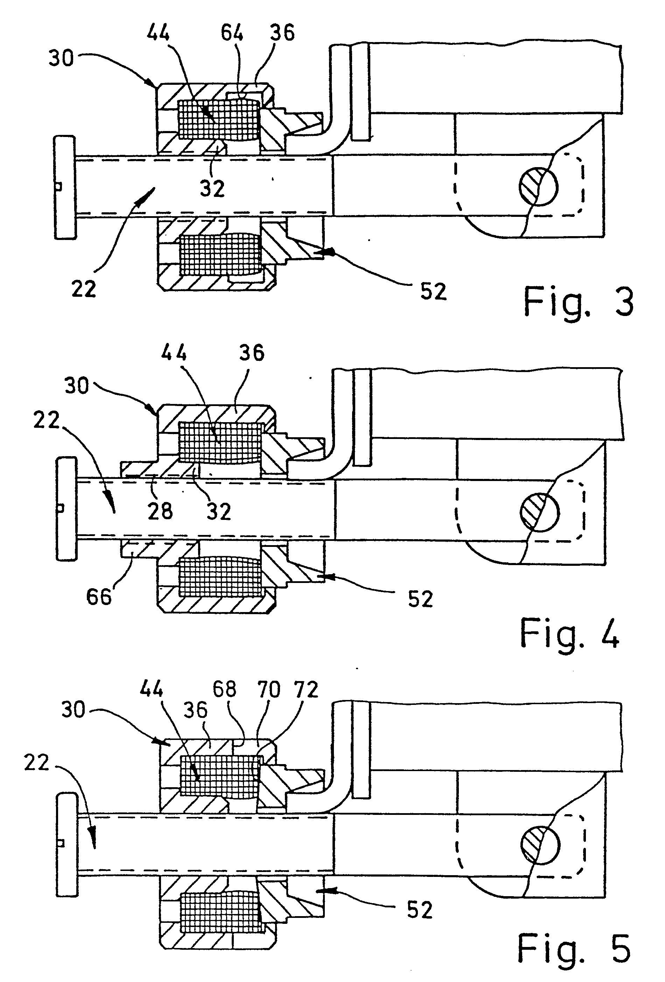

Die Fign. 3 bis 5 zeigen verschiedene Möglichkeiten der Gesamtfedercharakteristik des Spannriegels durch bloße Abänderung des Spannrings 30 und/oder des Halteringes 52, also von einfach abzuändernden Drehteilen.

Bei dem Spannring 30 nach Fig. 3 ist für den rechts gelegenen Abschnitt des Federkissens 44 auch an der außen liegenden Zylinderfläche ein radiales Ausweichen bei axialer Belastung möglich, da die Federkammer 42 dort durch eine flach eingestochene Nut 64 radial aufgeweitet ist.

Bei dem Spannring 30 nach Fig. 4 ist der für ein Ausweichen auf der Innenseite des Federkissens 44 vorgesehene Raum dadurch in axialer Richtung vergrößert, daß die axiale Abmessung des Stützstutzens 32 vermindert ist. Um trotzdem eine ausreichende Anzahl von Gängen des Gewindes 28 zu gewährleisten, ist mit dem Stützstutzen 32 fluchtend an den Boden 34 des Spannringes 30 axial nach außen überstehend ein Gewindestutzen 66 angeformt.

Bei dem Spannring 30 nach Fig. 5 ist für den rechts gelegenen Abschnitt des Federkissens 44 auf der Außenseite ein Ausweichen radial nach außen bei axialer Belastung möglich, da in die Umfangswand 36 zu ihrem freien Rand hin offene Schlitze 68 eingearbeitet sind, sodaß die dazwischen liegenden zungenförmigen Wandbereiche 70 radial nach außen federn können. Über die Anzahl und axiale Erstreckung der Schlitze 68 läßt sich das Gesamtfederverhalten des Spannriegels auf einfache Weise zusätzlich variieren.

Außerdem ist beim Ausführungsbeispiel nach Fig. 5 der Haltering 52 mit einer leicht kegeligen Stirnfläche 72 versehen, und über den Öffnungswinkel dieses Kegels läßt sich ebenfalls auf sehr einfache Weise bei vorgegebener Geometrie des Spannringes 30 und vorgegebenem Federkissen die Gesamtfedercharakteristik des Spannriegels noch einmal variieren.

In der Zeichnung sind Drähte des Federkissens 44 nur schematisch wiedergegeben und auch nur für die Schnittflächen eingezeichnet, um die Form der Kisseninnenkontur deutlicher zeigen zu können. Es versteht sich, daß in Wirklichkeit die Drähte nicht in genau regelmäßigem Abstand angeordnet sind.

Man erkennt, daß bei den oben beschriebenen Spannriegeln jeweils nur mechanisch einfach aufgebaute robuste Bauteile verwendet sind, nämlich Federkissen, Gewindebolzen, Spannring und Haltering. Die Spannkraft läßt sich jeweils unter Verwendung eines Drehmomentenschlüssels sehr präzise einstellen und auf diese Weise kann man die Resonanzfrequenz des durch Elektronikeinschub und Spannriegel gebildeten schwingungsfähigen Systems auf einfache Weise unter Berücksichtigung der Masse des Elektronikeinschubes so schieben, daß man nicht bei einer Resonanzfrequenz des Flugzeuges liegt. Dabei ist auch eine Variierung der Gesamtfedercharakteristik über die durch die Grenzeigenschaften eines Federkissens vorgegebenen Typs gesetzten Einstellgrenzen hinaus leicht durch geringfügige geometrische Abwandlung des Spannringes und/oder des Halteringes möglich, was keinerlei Schwierigkeiten bereitet, da beide Teile einfache Drehteile sind.

**Patentansprüche**

1. Riegel zum Verspannen eines elektronischen Gerätes an einer Geräteaufnahme (12), mit
a) einem Gewindebolzen (22), der bei seinem freien Ende mit Mitteln (20) zum Anlenken an der Geräteaufnahme (12) versehen ist und dessen Gewindesteigung eine Selbsthemmung unter den unter Arbeitsbedingungen angetroffenen Spannkräften gewährleistet,
b) einem auf dem Gewindebolzen (22) laufenden Spannring (30), welcher eine zum freien Ende des Gewindebolzens (22) hin offene Federkammer (42) aufweist,
c) einer in der Federkammer (42) angeordneten Federanordnung und
d) einem verschiebbar auf dem Gewindebolzen (22) zwischen dem Spannring (30) und den Anlenkmitteln (20) angeordneten Haltering (52), welcher eine zum freien Gewindebolzenende hin sich kegelförmig erweiternde Ausnehmung (56) zur Aufnahme eines Spannteiles (60) des Gerätes aufweist und auf seiner dem Spannring (30) zugewandten Stirnfläche (50) durch die Kraft der Federanordnung beaufschlagt ist,
dadurch gekennzeichnet, daß
e) die Federanordnung durch ein hohlzylindrisches Ganzmetall-Federkissen (44) gebildet ist,
f) das Federkissen (44) zumindest über einen Teil seiner axialen Erstreckung in radialer Richtung spielfrei zwischen der Außenwand (36) der Federkammer (42) und einem axial vom Federkammerboden (34) vorstehenden Stützstutzen (32) angeordnet ist, und
g) der Spannring (30) mit den ersten (46, 48) der zueinander komplementären Formschlußelemente einer steckbaren Formschlußverbindung versehen ist, an denen ein die zweiten Formschlußelemente tragender Drehmomentenschlüssel ansetzbar ist.

2. Riegel nach Anspruch 1, dadurch gekennzeichnet, daß der Spannring (30) beim freien Ende der Federkammer (42) eine radial nach innen überstehende, mit einer Einlauffläche (40) versehene Halterippe (38) aufweist, über welche das Federkissen (44) unter elastischer Verformung hinwegbewegbar ist.

3. Riegel nach Anspruch 1 oder 2, dadurch gekennzeichnet, daß die spannringseitige Stirnfläche (50) des Halteringes (52) unter geringem Spiel durch die Eintrittsöffnung der Federkammer (42) hindurchbewegbar ist.

4. Riegel nach einem der Ansprüche 1 bis 3, dadurch gekennzeichnet, daß die Außenwand (36) der Federkammer (42) über einen Teil ihrer axialen Erstreckung in radialer Richtung durch eine flache Nut (64) aufgeweitet ist.

5. Riegel nach einem der Ansprüche 1 bis 4, dadurch gekennzeichnet, daß in dem Stützstutzen (32) zugleich zumindest ein Teil des mit dem Gewindebolzen (22) zusammenarbeitenden Gewindes (28) des Spannringes (30) vorgesehen ist.

6. Riegel nach einem der Ansprüche 1 bis 5, dadurch gekennzeichnet, daß ein Teil des mit dem Gewindebolzen (22) zusammenarbeitenden Gewindes (28) des Spannringes (30) in einem axial über die freie Stirnfläche des Spannringes (30) überstehenden Gewindestutzen (66) angeordnet ist.

7. Riegel nach einem der Ansprüche 1 bis 6, dadurch gekennzeichnet, daß die Außenwand (36) der Federkammer (42) bei ihrem freien Ende mit bis zur freien Randkante durchlaufenden Schlitzen (68) versehen ist.

8. Riegel nach einem der Ansprüche 1 bis 7, dadurch gekennzeichnet, daß die spannringseitige Stirnfläche (50; 72) des Halteringes (52) entweder plan oder kegelförmig mit federkammerseitiger Kegelspitze ausgebildet ist.

9. Riegel nach einem der Ansprüche 1 bis 8, dadurch gekennzeichnet, daß die Metalldrähte im Federkissen (44) in Wellenlinien im wesentlichen in Umfangsrichtung verlaufen.

10. Riegel nach einem der Ansprüche 1 bis 9, dadurch gekennzeichnet, daß das Federkissen (44) aus einem rundgestrickten Cr-Ni-Stahldraht-Gewirk durch Kompaktieren auf eine Dichte von etwa 2 g/cm³ hergestellt ist, wobei die Dicke des verwendeten Stahldrahtes etwa 0,2mm beträgt.

11. Riegel nach Anspruch 10, dadurch gekennzeichnet, daß auch der Haltering (52) aus Stahl gefertigt ist.

**Claims**

1. Bolt for bracing an elektronic device on a device holder (12), with
a) a threaded bolt (22), which at its free end is provided with means (20) for connection to the device holder (12) and whereof the thread pitch ensures self-locking under the tensional forces encountered under working conditions,
b) a clamping ring (30) moving on the threaded bolt (22), which comprises a spring chamber (42) open towards the free end of the threaded bolt (22),
c) a spring arrangement located in the spring chamber (42) and
d) a retaining ring (52) arranged to move on the threaded bolt (22) between the clamping ring (30) and the connecting means (20), which ring (52) comprises a recess (56), enlarging conically towards the free end of the threaded bolt, for receiving a clamping part (60) of the device and at its end face (50) facing the clamping ring (30) is acted upon by the force of the spring arrangement, characterised in that
e) the spring arrangement is formed by a hollow cylindrical all-metal spring cushion (44),
f) the spring cushion (44) is arranged at least over part of its axial extent in the radial direction, without clearance between the outer wall (36) of the spring chamber (42) and a support connection (32) projecting axially from the bottom of the spring chamber (34), and

g) the clamping ring (30) is provided with the first (46, 48) of the complementary formlocking members of a plug-in type form-locking connection, to which a torque wrench supporting two form-locking members can be fitted.

2. Bolt according to Claim 1, characterised in that at the free end of the spring chamber (42), the clamping ring (30) comprises a retaining rib (38) projecting radially inwards and provided with an inlet surface (40), over which the spring cushion (44) is able to move with elastic deformation.

3. Bolt according to Claim 1 or 2, characterised in that the end face (50) of the retaining ring (52) adjacent the clamping ring can be moved with little clearance through the inlet opening of the spring chamber (42).

4. Bolt according to one of Claims 1 to 3, characterised in that over part of its axial extent, the outer wall (36) of the spring chamber (42) is widened out in the radial direction by a flat groove (64).

5. Bolt according to one of Claims 1 to 4, characterised in that provided in the support connection (32) at the same time is at least one part of the thread (28) of the clamping ring (30) cooperating with the threaded bolt (22).

6. Bolt according to one of Claims 1 to 5, characterised in that part of the thread (28) of the clamping ring (30) cooperating with the threaded bolt (22) is located in a threaded socket (66) projecting axially beyond the free end face of the clamping ring (30).

7. Bolt according to one of Claims 1 to 6, characterised in that at its free end, the outer wall (36) of the spring chamber (42) is provided with slots (68) extendingas far as the free marginal edge.

8. Bolt according to one of Claims 1 to 7, characterised in that the end face (50; 72) of the retaining ring (52) adjacent the clamping ring is constructed to be flat or conical with the apex of the cone adjacent the spring chamber.

9. Bolt according to one of Claims 1 to 8, characterised in that the metal wires in the spring cushion (44) extend in undulating lines substantially in the peripheral direction.

10. Bolt according to one of Claims 1 to 9, characterised in that the spring cushion (44) is made from a Cr-Ni-steel wire weft, formed by circular knitting, by compacting to a density of approximately 2g/cm³, in which case the thickness of the steel wire used amounts to approximately 0.2 mm.

11. Bolt according to Claim 10, characterised in that even the retaining ring (52) is made from steel.

## Revendications

1. Dispositif de verrouillage pour bloquer un appareil électrique sur un dispositif destiné à le recevoir (12), comprenant

a) une broche filetée (22) dont l'extrémité libre est munie de moyens d'articulation (20) au dispositif de réception de l'appareil (12) et dont le pas du filet assure un blocage automatique sous l'effet des forces de blocage se produisant dans les conditions de travail,

b) un anneau de blocage (30), qui est vissé sur la broche filetée (22) et qui comporte une chambre à ressort (42) débouchant vers l'extrémité libre de la broche filetée (22),

c) un agencement élastique disposé dans la chambre à ressort (42), et

d) un anneau d'appui (52), qui est monté coulissant sur la broche filetée (22) entre l'anneau de blocage (30) et les moyens d'articulation (20), qui comporte un évidement (56) s'évasant en forme de cone vers l'extrémité libre de la broche filetée et destiné à recevoir une pièce de blocage (60) de l'appareil et qui est soumis sur sa surface frontale (52) tournée vers l'anneau de blocage (30) à la force de l'agencement à ressort, caractérisé en ce que:

e) l'agencement élastique est formé par un coussin cylindrique ayant la caractéristique d'un ressort (44), entièrement métallique,

f) au moins une partie de l'étendue axiale du coussin élastique (44) est disposée sans jeu suivant la direction radiale entre la paroi extérieure (36) de la chambre à ressort (42) et un tube-support (32) en saillie axialement du fond (34) de la chambre à ressort, et

g) l'anneau de blocage (30) est muni des premiers éléments complémentaires (46, 48) d'une liaison par complémentarité de forme à enfichage, sur lesquels une clé dynamométrique portant les seconds éléments complémentaires peut être appliquée.

2. Dispositif de verrouillage suivant la revendication 1, caractérisé en ce que l'anneau de blocage (30) comporte, à l'extrémité libre de la chambre à ressort (42), une nervure d'appui (38) qui fait saillie radialement vers l'intérieur, qui est est munie d'une surface d'introduction et par laquelle le coussin élastique (44) peut être déplacé avec déformation élastique.

3. Dispositif de verrouillage suivant la revendication 1 ou 2, caractérisé en ce que la surface frontale (50) de l'anneau d'appui (52), qui se trouve du côté de l'anneau de blocage, peut être déplacée avec un faible jeu dans l'ouverture d'entrée de la chambre à ressort (42).

4. Dispositif de verrouillage suivant l'une des revendications 1 à 3, caractérisé en ce que la paroi extérieure (36) de la chambre à ressort (42) peut, sur une partie de son étendue axiale, être élargie suivant la direction radiale par une gorge (64) plane.

5. Dispositif de verrouillage suivant l'une des revendications 1 à 4, caractérisé en ce que, dans le tube-support (32) est prévue également au moins une partie du taraudage de l'anneau de blocage (30) cooperant avec la broche filetée (22)

6. Dispositif de verrouillage suivant l'une des revendications 1 à 5, caractérisé en ce qu'une partie du taraudage (28) de l'anneau de blocage (30) coopérant avec la broche filetée (22) est prévue dans une douille taraudée (66) en saillie axialement de la surface frontale libre de l'anneau de blocage (30).

7. Dispositif de verrouillage suivant l'une des revendications 1 à 6, caractérisé en ce que la paroi extérieure (36) de la chambre à ressort (42) est munie, à son extrémité libre, de fentes (68) allant jusqu'au bord marginal libre.

8. Dispositif de verrouillage suivant l'une des revendications 1 à 7, caractérisé en ce que la surface frontale (50; 72) de l'anneau d'appui (52), qui se trouve du côté de l'anneau de blocage, est plane ou conique avec le sommet du cône se trouvant du côté de la chambre à ressort.

9. Dispositif de verrouillage suivant l'une des revendications 1 à 8, caractérisé en ce que les fils métalliques du coussin élastique (44) s'étendent en des ondulations sensiblement suivant la direction du pourtour.

10. Dispositif de verrouillage suivant l'une des revendications 1 à 9, caractérisé en ce que le coussin élastique (44) un tissu à mailles en fil d'acier au Cr-Ni, tricoté au métier tubulaire, est amené par compactage à une masse volumique de 2 g/cm$^3$ environ, l'épaisseur du fil d'acier utilisé etant de 0,2 mm environ.

11. Dispositif de verrouillage suivant la revendication 10, caractérisé en ce que l'anneau d'appui (52) est aussi en acier.

Fig. 1

Fig. 2

1

Fig. 3

Fig. 4

Fig. 5